(19) **Europäisches Patentamt**
**European Patent Office**
**Office européen des brevets**

(11) **EP 3 175 550 B1**

(12) **FASCICULE DE BREVET EUROPEEN**

(45) Date de publication et mention
de la délivrance du brevet:
**07.11.2018 Bulletin 2018/45**

(21) Numéro de dépôt: **15762490.9**

(22) Date de dépôt: **30.07.2015**

(51) Int Cl.:
**H03D 7/16** $^{(2006.01)}$ **H03H 17/02** $^{(2006.01)}$
**H03H 17/06** $^{(2006.01)}$

(86) Numéro de dépôt international:
**PCT/EP2015/067605**

(87) Numéro de publication internationale:
**WO 2016/016409 (04.02.2016 Gazette 2016/05)**

(54) **CONVERTISSEUR NUMÉRIQUE DE FRÉQUENCE ET PROCÉDÉ DE TRAITEMENT DANS UN CONVERTISSEUR NUMÉRIQUE DE FRÉQUENCE**

DIGITALER FREQUENZWANDLER UND VERFAHREN ZUR VERARBEITUNG IN EINEM DIGITALEN FREQUENZWANDLER

DIGITAL FREQUENCY CONVERTER AND METHOD OF PROCESSING IN A DIGITAL FREQUENCY CONVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.07.2014 FR 1401758**

(43) Date de publication de la demande:
**07.06.2017 Bulletin 2017/23**

(73) Titulaire: **Thales**
**92400 Courbevoie (FR)**

(72) Inventeurs:
• **JOLEC, François**
**F-49309 Cholet (FR)**
• **DOUMENJOU, Anthony**
**F-49309 Cholet (FR)**

(74) Mandataire: **Lavoix**
**2, place d'Estienne d'Orves**
**75441 Paris Cedex 09 (FR)**

(56) Documents cités:
**EP-A2- 1 443 645     US-A- 5 841 811**
**US-A1- 2004 056 785**

• **LANGLOIS J M P ET AL: "A high performance, wide bandwidth, low cost FPGA-based quadrature demodulator", ELECTRICAL AND COMPUTER ENGINEERING, 1999 IEEE CANADIAN CONFERENCE ON EDMONTON, ALTA., CANADA 9-12 MAY 1999, PISCATAWAY, NJ, USA,IEEE, US, 9 mai 1999 (1999-05-09), pages 497-502vol.1, XP032158310, DOI: 10.1109/CCECE.1999.807248 ISBN: 978-0-7803-5579-8**

• **JOGERSEN J H ED - STEIN T I (ED): "DIGITAL DEMODULATOR FOR WIDE BANDWIDTH SAR", IGARSS 2000. IEEE 2000 INTERNATIONAL GEOSCIENCE AND REMOTE SENSING SYMPOSIUM. HONOLULU, HAWAII, JULY 24 - 28, 2000; [IEEE INTERNATIONAL GEOSCIENCE AND REMOTE SENSING SYMPOSIUM], NEW YORK, NY : IEEE, US, 24 juillet 2000 (2000-07-24), pages 2269-2271, XP000970975, ISBN: 978-0-7803-6360-1**

**Description**

La présente invention concerne un convertisseur numérique de fréquence.

De tels convertisseurs numériques sont utilisés pour effectuer une conversion descendante de fréquence, transformant des échantillons réels provenant d'un convertisseur analogique-numérique et centrés sur une fréquence transposée $f_0$, en des échantillons complexes I/Q en bande de base, suivie d'un filtrage passe-bas et d'une décimation.

Les convertisseurs numériques de fréquence connus de l'art antérieur sont décrits dans les documents : US5841811, US2004056785, et dans l'article de J.M.P. Langlois et al. "A High Performance, Wide Bandwidth, Low Cost FPGA-Based Quadrature Demodulator", Proceedings of the 1999 IEEE Canadian Conférence on Electrical and Computer Engineering, Edmonton, Alberta, Canada, May 9-12 1999, pages 497-502.

Ces convertisseurs numériques de fréquence sont souvent implémentés sur un circuit imprimé de type réseau de portes programmables, dit encore FPGA (en anglais « field-programmable gate array »), opérant à une vitesse de traitement $F_{FPGA}$ inférieure à la fréquence d'échantillonnage $F_e$ du convertisseur analogique-numérique. La conversion de fréquence ne se fait donc pas en continu et en temps réel, ou bien il est nécessaire de limiter la fréquence d'échantillonnage par la fréquence de traitement $F_{FPGA}$ si un traitement en continu et en temps réel est souhaité.

Il est parfois utilisé plusieurs blocs convertisseurs analogiques-numériques à des fréquences d'échantillonnage inférieure à $F_{FPGA}$ pour avoir un équipement large bande, mais des problèmes de jonction entre les différents blocs se posent.

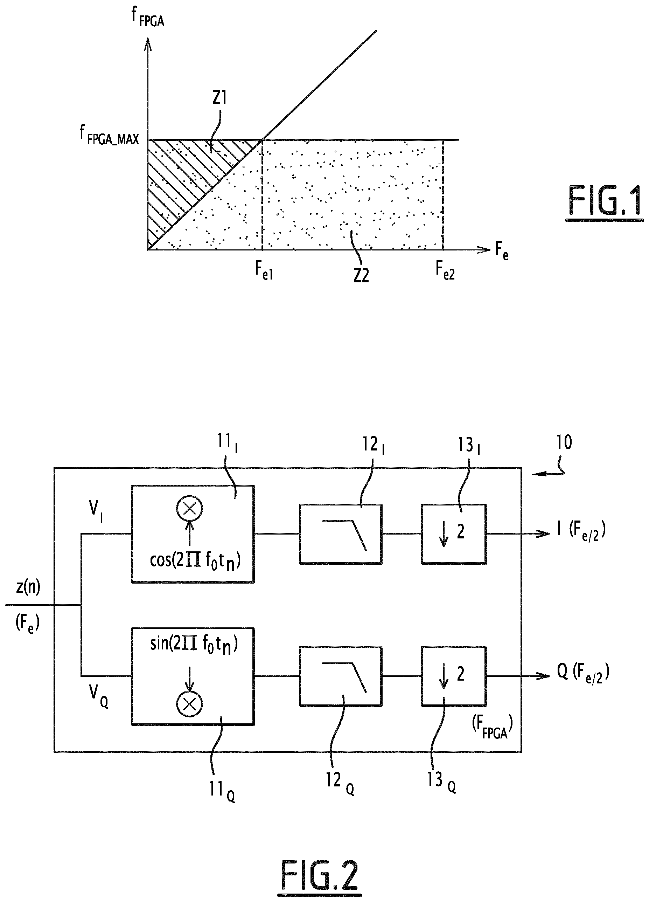

En référence au graphe de la figure 1 représentant en abscisse la fréquence d'échantillonnage $F_e$ et en ordonnée la fréquence de traitement $F_{FPGA}$, et en notant $F_{FPGA\_MAX}$ la valeur maximale de traitement du FPGA, la zone hachurée Z1 est la zone exploitable en traitement continu et en temps réel, et la fréquence $F_{e1}$ est la fréquence d'échantillonnage maximale utilisable pour un traitement continu et en temps réel.

Il est donc souhaitable de disposer d'un convertisseur numérique permettant de réduire le nombre de calculs nécessaires à la conversion d'une part, et d'autre part d'effectuer le traitement, à la fréquence de traitement $F_{FPGA}$ du FPGA rythmant le fonctionnement du convertisseur, des échantillons échantillonnés à une fréquence d'échantillonnage $F_e$ supérieure à cette fréquence de traitement $F_{FPGA}$.

A cet effet, suivant un premier aspect, l'invention propose un convertisseur numérique de fréquence adapté pour recevoir des échantillons de signal et comprenant :

- au moins un bloc de transposition en fréquence adapté pour transposer en fréquence lesdits échantillons reçus ;
- au moins un bloc de filtrage adapté pour filtrer lesdits échantillons transposés et pour délivrer des échantillons filtrés y(n) vérifiant la formule y(n) =c(0).x(n) + c(1).x(n-1) + c(2).x(n-2)+... + c(p-1).x(n-p+1) + c(p).x(n-p) + c(p-1).x(n-p-1)+...+...+c(1).x(n-2.p+1) + c(0).x(n-2.p), où x() sont les échantillons transposés et c(0),...c(p) sont des coefficients réels du filtre ; et

- un ensemble de mémoires,

ledit convertisseur de fréquences étant adapté pour, lors d'un cycle de détermination de la valeur de l'échantillon filtré y(n), effectuer les opérations de

- calcul des premiers termes c(0).x(n), c(1).x(n-1), c(2).x(n-2),..., c(p).x(n-p) en multipliant les coefficients et échantillons transposés respectifs, et stockage d'au moins certains desdits premiers termes calculés dans l'ensemble de mémoires ;
- lecture, dans l'ensemble de mémoires, d'au moins certains des seconds termes c(p-1).x(n-p-1),..., c(1).x(n-2.p+1), c(0).x(n-2.p), calculés et stockés lors de cycles précédents de détermination de la valeur d'échantillons filtrés y(n-m), avec m entier strictement positif ; et
- détermination de y(n) par sommation des premiers et seconds termes,

ledit convertisseur de fréquences étant adapté pour recevoir des échantillons réels échantillonnés de signal et pour délivrer des signaux complexes I/Q, issus du filtrage par le bloc de filtrage après transposition par le bloc de transposition desdits échantillons réels échantillonnés, ledit convertisseur comportant des chaînes parallèles de traitement des signaux I et des signaux Q, au moins une desdites chaînes de traitement I, Q comprenant N voies parallèles adaptées chacune pour effectuer une transposition de fréquence, ledit convertisseur de fréquences étant adapté pour ème répartir sélectivement les échantillons réels entre lesdites voies, chaque (N.n+i-1) échantillon réel étant fourni à la $i^{ème}$ voie, i = 1 à N, n étant un entier positif,

au moins la $k^{ème}$ et $j^{ème}$ voies parallèles de ladite chaîne de traitement, k≠j et k, j entiers entre 1 et N, comprenant un sous-bloc de filtrage adapté pour déterminer le signal filtré y(N.n+i-1) = c(0).x(N.n+i-1) + c(1).x(N.n+i-1-1) + c(2).x(N.n+i-1-2) +... + c(p-1).x(N.n+i-p) + c(p).x(N.n+i-1-p) + c(p-1).x(N.n+i-1-p-1)...+ c(1).x(N.n+i-1-2.p+1) + c(0).x(N.n+i-1-2.p), où x() sont les signaux issus de la transposition dans ladite chaîne de traitement, avec i = j sur la j<sup>ème</sup> voie, et i = k sur la k<sup>ème</sup> voie,

le sous-bloc de filtrage de la k<sup>ème</sup> voie, respectivement de la j<sup>ème</sup> voie, étant adapté pour calculer les premiers termes c(0).x(N.n+i-1), ..., c(p).x(N.n+i-1-p) en multipliant les coefficients et échantillons transposés respectifs, pour stocker d'au moins certains desdits premiers termes calculés dans l'ensemble de mémoires et pour lire, dans l'ensemble de mémoires, au moins certains des seconds termes c(p-1).x(N.n+i-1-p-1), ..., c(0).x(N.n+i-1 -2.p), calculés et stockés lors de cycles précédents de détermination de la valeur d'échantillons filtrés y(n-m), avec m entier strictement positif, certains desdits seconds termes ayant été calculés par le sous-bloc de filtrage de la j<sup>ème</sup> voie, respectivement de la k<sup>ème</sup> voie.

Un tel convertisseur, en exploitant les propriétés des filtres symétriques permet de diminuer le volume de calcul à réaliser et donc de limiter les ressources nécessaires pour la conversion.

Dans des modes de réalisation, le convertisseur numérique de fréquence suivant l'invention comporte en outre une ou plusieurs des caractéristiques suivantes :

- le convertisseur est adapté pour fonctionner de manière cadencée par un signal d'horloge de fréquence, dite fréquence de fonctionnement, et adapté pour recevoir les échantillons réels échantillonnées selon une fréquence d'échantillonnage, N étant égal au quotient de la fréquence d'échantillonnage par la fréquence de fonctionnement ;
- la transposition de fréquence comprend une multiplication des échantillons par un sinus ou cosinus de fréquence égale à $F_e/4$, N/2 voies délivrant ainsi des échantillons transposés toujours nuls.

Suivant un deuxième aspect, la présente invention propose un procédé de traitement dans un convertisseur de fréquence adapté pour recevoir des échantillons de signal, le procédé comprenant les étapes suivantes :

- réception des échantillons de signal ;
- transposition en fréquence desdits échantillons reçus ;
- filtrage desdits échantillons transposés, les échantillons filtrés y(n) vérifiant la formule y(n) =c(0).x(n) + c(1).x(n-1) + c(2).x(n-2)+... + c(p-1).x(n-p+1) + c(p).x(n-p) + c(p-1).x(n-p-1)+...+c(1).x(n-2.p+1) + c(0).x(n-2.p), où x() sont les échantillons transposés et c(0),...c(p) sont des coefficients réels du filtre ;

ledit procédé de traitement comprenant les étapes suivantes, lors d'un cycle de détermination de la valeur de l'échantillon filtré y(n) :

- calcul des premiers termes c(0).x(n), c(1).x(n-1), c(2).x(n-2),..., c(p).x(n-p) en multipliant les coefficients et échantillons transposés respectifs, et stockage d'au moins certains desdits premiers termes calculés dans un ensemble de mémoires ;
- lecture, dans l'ensemble de mémoires, d'au moins certains des seconds termes c(p-1).x(n-p-1),..., c(1).x(n-2.p+1), c(0).x(n-2.p), calculés et stockés lors de cycles précédents de détermination de la valeur d'échantillons filtrés y(n-m), avec m entier strictement positif ; et
- détermination de y(n) par sommation des premiers et seconds termes,

le convertisseur de fréquences étant adapté pour recevoir des échantillons réels échantillonnés de signal et délivrer des signaux complexes I/Q issus du filtrage après transposition desdits échantillons réels échantillonnés, ledit procédé comprenant les étapes de :

- traitement en parallèle des échantillons réels sur une chaîne de traitement I de signaux I et une chaîne de traitement Q de signaux Q ;
- sur au moins une desdites chaînes de traitement parallèle comprenant N voies parallèles, ème

répartition sélective des échantillons réels entre lesdites voies, chaque (N.n+i-1) échantillon réel étant fourni à la i<sup>ème</sup> voie, i = 1 à N, n étant un entier positif,

le procédé de traitement comprenant, sur au moins la k<sup>ème</sup> et j<sup>ème</sup> voies parallèles de ladite chaîne de traitement, k≠j et k, j entiers entre 1 et N, la détermination du signal filtré y(N.n+i-1) = c(0).x(N.n+i-1) + c(1).x(N.n+i-1-1) + c(2).x(N.n+i-1-2) +... + c(p-1).x(N.n+i-p) + c(p).x(N.n+i-1-p) + c(p-1).x(N.n+i-1-p-1)...+c(1).x(N.n+i-1-2.p+1) + c(0).x(N.n+i-1 -2.p), où x() sont les signaux issus de la transposition dans ladite chaîne de traitement, avec i = j sur la j<sup>ème</sup> voie, et i = k sur la k<sup>ème</sup> voie,

et comprenant sur la k<sup>ème</sup> voie, respectivement de la j<sup>ème</sup> voie, le calcul des premiers termes c(0).x(N.n+i-1), ..., c(p).x(N.n+i-1-p) en multipliant les coefficients et échantillons transposés respectifs, le stockage d'au moins certains desdits premiers termes calculés dans l'ensemble de mémoires et la lecture dans l'ensemble de mémoires, d'au moins certains des seconds termes c(p-1).x(N.n+i-1-p-1), ..., c(0).x(N.n+i-1 -2.p), calculés et stockés lors de cycles précédents de détermination de la valeur d'échantillons filtrés y(n- m), avec m entier strictement positif, sur la j$^{ème}$ voie, respectivement la k$^{ème}$ voie.

Ces caractéristiques et avantages de l'invention apparaîtront à la lecture de la description qui va suivre, donnée uniquement à titre d'exemple, et faite en référence aux dessins annexés, sur lesquels :

- la figure 1 représente un graphe illustrant la relation entre la fréquence d'échantillonnage et la fréquence de traitement dans l'art antérieur d'une part et selon l'invention d'autre part ;
- la figure 2 est une vue d'un convertisseur de fréquence de type descendant ;
- la figure 3 est une vue détaillée d'un convertisseur de fréquence de type descendant dans un mode de réalisation de l'invention ;
- la figure 4 est un organigramme d'étapes mises en oeuvre dans un mode de réalisation de l'invention.

La figure 2 est une vue d'un convertisseur de fréquence de type descendant 10.

Le convertisseur de fréquence de type descendant 10 ou DDC 10 (en anglais « Digital Down Converter ») est adapté pour recevoir en entrée des échantillons réels z(n) en bande transposée.

Le DDC 10, en anglais « Digital Down Converter ») est adapté pour délivrer en sortie des échantillons complexes Z(n) en bande de base, i.e dont le spectre est centré sur 0.

z(n) est l'échantillon correspondant au temps d'échantillonnage $t_n = n/F_e$ et Z(n) est l'échantillon délivré à $T_{init}+n/F_e$ où n est un entier positif et l'instant d'échantillonnage initial.

Chaque échantillon complexe s'écrit Z(n) = I(n) +i.Q(n), où I(n) est la composante en phase et Q(n) est la composante en quadrature.

Le spectre de ces échantillons z(n) est ainsi centré autour de la fréquence porteuse $f_0$.

La fréquence d'échantillonnage $F_e$ de ces échantillons z(n) est par exemple la fréquence d'échantillonnage d'un convertisseur analogique-numérique situé en amont du DDC 10.

Le DDC 10 est partie intégrante d'un FPGA et ses opérations sont rythmées par un signal d'horloge du FPGA ayant une fréquence égale à $F_{FPGA}$, nommée fréquence de traitement.

Le DDC 10 est adapté pour traiter en continu et en temps réel les échantillons z(n) reçu. Le DDC 10 comporte une voie de traitement $V_I$ et une voie de traitement $V_Q$.

Le DDC 10 est adapté pour fournir chaque échantillon réel z(n) en entrée de chaque voie de traitement $V_I$ et $V_Q$.

Le DDC 10 comprend, sur la voie $V_I$, un bloc de transposition en bande de base, $11_I$, un filtre passe-bas $12_I$ et un bloc décimateur $13_I$.

Le DDC 10 comprend, sur la voie $V_Q$, un bloc de transposition en bande de base, $11_Q$, un filtre passe-bas $12_Q$ et un bloc décimateur $13_Q$.

Le bloc de transposition de fréquence $11_I$ est adapté pour multiplier un échantillon réel z(n) reçu en entrée par une fonction cosinus à la fréquence $f_0$ : $\cos(2\pi f_0 t_n)$.

Le bloc de transposition de fréquence $11_Q$ est adapté pour multiplier un échantillon réel z(n) par une fonction sinus à la fréquence $f_0$ : $-\sin(2\pi f_0 t_n)$.

Chaque bloc décimateur $13_I$, $13_Q$ est adapté pour réduire le nombre d'échantillons, dans le cas considéré le nombre d'échantillons est réduit d'un facteur 2. Cette décimation réduit le cadencement sur la voie I, respectivement Q, de 800 MHz à 400 MHz.

Dans le cas considéré, chaque filtre $12_I$, $12_Q$ est un filtre à réponse impulsionnelle finie, dit filtre FIR (en anglais « Finite Impulse Response filter »).

La sortie y(n) de chacun de ces filtres $12_I$, $12_Q$ s'écrit sous la forme d'une même combinaison linéaire fonction du signal d'entrée x(n) du filtre:

$$y(n) = c(0).x(n) + c(1).x(n-1) + c(2).x(n-2)…+ c(M-1).x(n-M+1) \qquad \textit{(formule 1)}$$

où M est un nombre entier positif.

Dans le mode de réalisation décrit, chaque filtre est un filtre symétrique, avec les propriétés suivantes :

- le nombre M de coefficients est impair: M= 2.p+1 avec p entier positif ;
- les coefficients sont des nombres réels et sont symétriques c(i) = c(2.p-i) i = 0 àp ;
- les coefficients impairs sont nuls sauf le coefficient impair parmi c(p) et c(p+1).

Dans le mode de réalisation décrit, chaque filtre est en outre normalisé par la valeur du coefficient central c(p).

La formule donnant y(n) peut donc s'écrire :

$$y(n) = c(0).x(n) + c(1).x(n-1) + c(2).x(n-2) + \ldots + c(p-1).x(n-p+1) + c(p).x(n-p) + c(p-1).x(n-p-1)\ldots + c(1).x(n-2.p+1) + c(0).x(n-2.p).$$

On remarque que les p derniers termes de la combinaison linéaire, à compter du terme c(p-1).x(n-p-1) jusqu'au terme c(0).x(n-2.p) sont des termes utilisés pour déterminer des sorties précédentes du filtre :

c(0).x(n-2.p) entre dans le calcul de y(n-2.p),
c(1).x(n-2.p+1) entre dans le calcul de y(n-2.p+2),
c(p-1).x(n-p-1) entre dans le calcul de y(n-2) ; et
plus généralement c(i).x(n-2p+i) entre dans le calcul de y(n-2p+2i), i = 0 à p-1.

Similairement, les p premiers termes de la combinaison linéaire, à compter du terme c(0).x(n) jusqu'au terme c(p-1).x(n-p+1) sont des termes utilisés pour déterminer des sorties ultérieures du filtre.

Selon un aspect de l'invention, le nombre de multiplications à réaliser, et donc le nombre de multiplicateurs à mettre en place sera réduit par la mise en place lors du calcul d'une sortie y(n) de filtre, de mémorisation des p premiers termes de la combinaison linéaire suite à leur calcul, appelés ci-après résultats intermédiaires, et de l'extraction et réutilisation des résultats intermédiaires précédemment mémorisés lors du calcul de sorties précédentes, pour déterminer les p derniers termes de la combinaison linéaire.

Le DDC 10 selon l'invention est adapté pour réaliser les traitements sur chaque voie parallèle à la fréquence $F_{FPGA}$ et délivrer en sortie un flux I et un flux Q, chaque flux étant un flux continu et en temps réel d'échantillons à $F_e/2$.

Dans le cas particulier considéré :

- p est choisi égal à 27, le nombre de coefficients est donc égal à 55 ;
- les coefficients sont les suivants : c(0), c(1), c(2), ..., c(25), c(26), c(27), c(28), c(29), ..., c(52), c(53), c(54) ;
- c(0), c(2), ..., c(52), c(54) valent entre -1 et 1 après normalisation par le coefficient central c(27);
- les coefficients impairs sont nuls c(1)=c(3)= ... =c(25)=c(29)= ...=c(51)=c(53)=0 sauf c(27) égal à 1 suite à la normalisation des coefficients ;
- la fréquence transposée $f_0$ est égale à 200 MHz, la fréquence d'échantillonnage $F_e$ est égale à 800 MHz, la fréquence $F_{FPGA}$ de traitement du FGPA est égale à 200 MHz.

Mais l'invention peut bien sûr être mise en oeuvre avec d'autres valeurs pour p et ces fréquences.

Des échantillons successifs y(n), y(n+1) sur la voie I en sortie du filtre $12_I$ s'écrivent donc en fonction des échantillons x(i) en entrée du filtre $12_I$ du fait que la transposition donne lieu à un échantillon égal à 0 tous les deux échantillons du fait de la valeur des $2\pi f_0 t_i$ :

$$\begin{aligned} y(n) = c(0) * x(n) + 0 * 0 + c(2) * x(n-2) + 0 * 0 + \cdots + 0 * 0 + c(26) * x(n-26) + 1 * 0 \\ + c(28) * x(n-28) + 0 * 0 + \cdots + c(52) * x(n-52) + 0 * 0 + c(54) \\ * x(n-54) \end{aligned}$$

comme les échantillons nuls en entrée suite à la transposition et les coefficients nuls se superposent et y(n) est une somme de 28 termes ; et

$$\begin{aligned} y(n+1) = c(0) * 0 + 0 * x(n) + c(2) * 0 + 0 * x(n-2) + \cdots + c(26) * 0 + 1 * x(n-26) \\ + c(28) * 0 + \cdots + 0 * x(n-52) + c(54) * 0 \end{aligned}$$

Du fait de l'annulation des termes à l'exception d'un terme, soit par échantillons nuls soit par coefficients nuls, y(n+1) = x(n-26). Il n'y a donc aucun calcul à faire, juste un retard est appliqué.

Des échantillons successifs y(n), y(n+1) sur la voie Q en sortie du filtre $12_Q$ s'écrivent donc similairement en fonction des échantillons x(i) en entrée du filtre $12_Q$ du fait que la transposition donne lieu à un échantillon égal à tous les deux échantillons du fait de la valeur des $2\pi f_0 t_i$ : y(n) = x(n-27) et y(n+1) s'écrit comme une somme de 28 termes.

La décimation des échantillons par 2 revient à ne conserver qu'un échantillon sur 2, i.e. suivant les modes de réalisation soit y(n) ou y(n+1).

Dans le cas considéré décrit ci-dessous, il est considéré que les échantillon y(n) sont supprimés et les échantillons y(n+1) sont conservés, ce qui induit la mise en oeuvre d'un retard sur la voie I et d'un filtre FIR à 28 coefficients comme décrit ci-dessous.

Les coefficients étant symétriques ($c(0) = c(54)$, $c(1)=c(53)=0$, $c(2)=c(52)$, ...), ceci implique donc 14 multiplications.

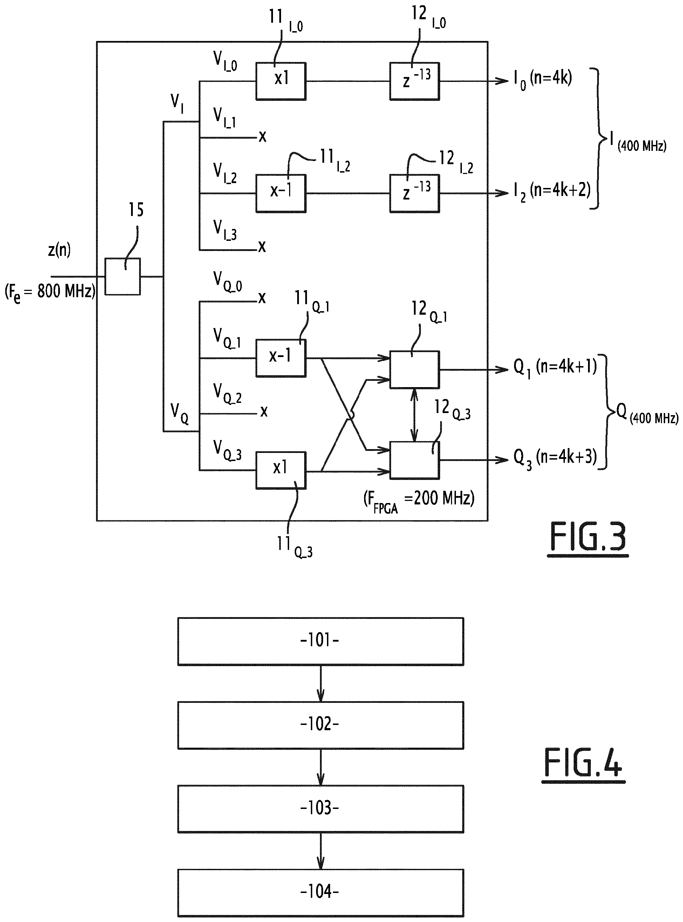

La figure 3 illustre un mode de réalisation particulier du DDC 10 représenté en figure 2.

Le DDC 10 dans ce mode de réalisation comprend un distributeur 15 adapté pour recevoir les échantillons $z(n)$ à la fréquence $F_e =800$ MHz et pour traiter les échantillons N par N, avec $N = F_e/F_{FPGA}$, ici $N= 4$.

Le traitement de ce distributeur 15 comprend la fourniture en parallèle de chacun de ces N échantillons en entrée de la voie $V_I$ et la fourniture en parallèle de chacun de ces N échantillons en entrée de la voie $V_Q$.

La voie $V_I$ du DDC 10 comprend ainsi N sous-voies $V_{I\_0},..., V_{I\_N-1}$.

Chaque sous-voie $V_{I\_i}$ i =0 à N-1, reçoit sélectivement les échantillons $z(kN+i)$, avec k entier naturel.

Chaque sous-voie $V_{I\_i}$ est adaptée pour effectuer en parallèle des autres sous-voies de la voie $V_I$, la transposition de fréquence en bande de base par la multiplication par $\cos(2\pi f_0 t_n)$ dans un bloc de transposition en bande de base $11_{I\_i}$, et le filtrage FIR par un bloc de filtrage $12_{I\_i}$.

Similairement, la voie $V_Q$ du DDC 10 comprend ainsi N sous-voies $V_{Q-0,...}, V_{Q-N-1}$.

Chaque sous-voie $V_{Q\_i}$ i =0 à N-1, reçoit sélectivement les échantillons $z(kN+i)$, avec k entier naturel.

Chaque sous-voie $V_{Q\_i}$ est adaptée pour effectuer en parallèle des autres sous-voies de la voie $V_Q$, la transposition de fréquence en bande de base par la multiplication par $-\sin(2\pi f_0 t_n)$ dans un bloc de transposition en bande de base $11_{Q\_i}$, et le filtrage FIR par un bloc de filtrage $12_{Q\_i}$.

Les blocs de filtrage $12_{Q\_1}$ et $12_{Q\_3}$ sont en outre adaptés pour calculer et mémoriser des résultats intermédiaires, par exemple dans des registres à décalage et communiquer entre eux ces résultats intermédiaires, par exemple par l'intermédiaire de moyens d'entrée/sortie desdits registres accéder.

Dans le cas particulier considéré avec les valeurs indiquées ci-dessus pour p et les fréquences, du fait que $F_e/f_0 = 4$, il s'avère que la transposition en bande de base sur les sous-voies $V_{I\_1}$, $V_{I\_3}$, $V_{Q-0}$ et $V_{Q\_2}$ délivre toujours une valeur nulle. En conséquence, dans le cas particulier considéré, le DDC 10 ne comporte en réalité dans chacune des voies $V_I$ et $V_Q$ que $N/2 = 2$ sous-voies : $V_{I\_0}$ et $V_{I\_2}$ dans la voie $V_I$ et $V_{Q\_1}$ et $V_{Q\_3}$ dans la voie $V_Q$.

Dans le mode de réalisation considéré, du fait que $F_e/f_0 = 4$, que $t_n= n/F_e$ et des signaux reçus sur chaque sous-voie :

- sur la voie $V_{I\_0}$, la multiplication par $\cos(2\pi f_0 t_n)$ dans le bloc de transposition en bande de base $11_{I\_0}$ équivaut à la multiplication par un facteur 1 ;

- sur la voie $V_{I\_2}$, la multiplication par $\cos(2\pi f_0 t_n)$ dans le bloc de transposition en bande de base $11_{I\_2}$ équivaut à la multiplication par un facteur -1 ;

- sur la voie $V_{Q\_1}$, la multiplication par $-\sin(2\pi f_0 t_n)$ dans le bloc de transposition en bande de base $11_{Q\_1}$ équivaut à la multiplication par un facteur -1 ;

- sur la voie $V_{Q\_3}$, la multiplication par $-\sin(2\pi f_0 t_n)$ dans le bloc de transposition en bande de base $11_{Q\_3}$ équivaut à la multiplication par un facteur 1.

Sur les sous-voies $V_{I\_0}$ et $V_{I\_2}$, l'application du filtrage équivaut à l'application d'un retard par l'application de la fonction de transfert $z^{-13}$ : si on appelle $I_0$ la sortie du filtre sur la sous-voie $V_{I\_0}$ et $I_2$ la sortie du filtre sur la sous-voie $V_{I\_2}$ : $I_0(n=4k)= z(n-14)$ et $I_2(n=4k+2)= z(n-12)$ En effet, le retard théorique correspond à p-1 (= 26) comme indiqué précédemment divisé par deux suite à l'opération de décimation, soit (p-1)/2 (= 13) ; comme le calcul de filtrage sur la voie Q dure plus longtemps que 13 cycles d'horloge, la voie I est en outre retardée de manière à être synchronisée avec la voie Q.

Les échantillons issus du passage en bande de base de la voie $V_{Q\_1}$ et de la voie $V_{Q\_3}$ sont fournis en entrée de chaque bloc de filtrage FIR $12_{Q\_1}$ et $12_{Q\_3}$.

Le bloc de filtrage $12_{Q\_1}$ sur la sous-voie $V_{Q\_1}$ est adapté pour déterminer le résultat de la combinaison linéaire ; si on appelle $Q_1$ la sortie du filtre sur la sous-voie $V_{Q\_1}$ :

$$Q_1(n=4k+1)= -c(0)z(4k+1) + c(2)z(4k-1) -c(4)z(4k-3) ...+ c(26)z(4k-25) - c(26)z(4k-27)...-$$

$$c(0)z(4k-53).$$

Pour ce faire, il est adapté pour calculer chaque terme de la première moitié de la combinaison linéaire, i.e. les termes $c(0)z(4k+1)$, $c(2)z(4k-1)$, $c(4)z(4k-3)$ ..., $c(26)z(4k-25)$ en fonction des coefficients du filtre $c(0)$, ..., $c(26)$ et des échantillons en bande de base reçus $-z(4k+1)$, $+ z(4k-1)$..., $z(4k-25)$, et pour mémoriser comme résultat intermédiaire le résultat de chacun de ces termes. Chacun de ces résultats intermédiaires mémorisés est rendu accessible en outre au bloc de filtrage $12_{Q\_3}$.

Le bloc de filtrage $12_{Q\_1}$ est en outre adapté pour extraire des mémoires dans lesquelles ils ont été précédemment stockés, les termes de la deuxième moitié de la combinaison linéaire, i.e. $c(26)z(4k-27)$, $c(24)z(4k-29)$,...,$c(0)z(4k-$

53), et pour déterminer la somme des termes de la première moitié et des termes de la deuxième moitié moyennant la prise en compte des signes de ces termes.

Similairement, le bloc de filtrage $12_{Q\_3}$ sur la sous-voie $V_{Q\_3}$ est adapté pour déterminer le résultat de la combinaison linéaire ; si on appelle $Q_3$ la sortie du filtre sur la sous-voie $V_{Q\_3}$ :

$$Q_3(n=4k+3)= c(0)z(4k+3) - c(2)z(4k+1) +c(4)z(4k-1) \ldots - c(26)z(4k-23) + c(26)z(4k-25)\ldots+ c(0)z(4k-51).$$

Pour ce faire, il est adapté pour calculer chaque terme de la première moitié de la combinaison linéaire, i.e. les termes $c(0)z(4k+3)$, $c(2)z(4k+1)$, $c(4)z(4k-1)$ ..., $c(26)z(4k-23)$ en fonction des coefficients du filtre $c(0)$, ..., $c(26)$ et des échantillons en bande de base reçus $z(4k+3)$, $z(4k+1)$..., $-z(4k-23)$, et pour mémoriser comme résultat intermédiaire le résultat de chacun de ces termes. Chacun de ces résultats intermédiaires mémorisés est rendu accessible en outre au bloc de filtrage $12_{Q\_1}$.

Le bloc de filtrage $12_{Q\_3}$ est en outre adapté pour extraire des mémoires dans lesquelles ils ont été précédemment stockés, les termes de la deuxième moitié de la combinaison linéaire, i.e. $c(26)z(4k-25)$, $c(24)z(4k-27)$,...,$c(0)z(4k-51)$, et pour déterminer la somme des termes de la première moitié et des termes de la deuxième moitié moyennant la prise en compte des signes de ces termes.

Le DDC 10 délivre ainsi, simultanément, en sortie de la voie I, les échantillons $I_0(n=4k)$ et $I_2(n=4k+2)$ et, en sortie de la voie Q, les échantillons $Q_1(n=4k+1)$ et $Q_3(n=4k+3)$.

On considère que les échantillons I pairs du DDC 10 sont fournis par la sous-voie $I_0$, que les échantillons I impairs du DDC 10 sont fournis par la sous-voie $I_2$, que les échantillons Q pairs du DDC 10 sont fournis par la sous-voie $Q_1$, que les échantillons Q impairs du DDC 10 sont fournis par la sous-voie $Q_3$.

L'invention propose, suivant un aspect, un procédé de traitement dans un convertisseur de fréquence.

Dans un mode de réalisation, en référence à la figure 4, les étapes suivantes sont mises en oeuvre.

Dans une étape 101, les échantillons $z(n)$ à la fréquence $F_e$ =800 MHz sont reçus dans le DDC 10 et fournis en parallèle, N par N, en entrée de la voie $V_I$ et en entrée de la voie $V_Q$.

Dans une étape 102, dans chaque sous-voie $V_{P\_i}$ en parallèle des autres sous-voies de la voie $V_I$, la transposition de fréquence en bande de base par la multiplication par $\cos(2\pi f_0 t_n)$ dans un bloc de transposition en bande de base $11_{I\_i}$ est réalisée, P=I ou Q et i =0 à N-1.

Chaque sous-voie $V_{P\_i}$ reçoit sélectivement les échantillons $z(kN+i)$, avec k entier naturel.

Les échantillons issus de la transposition effectuée dans une sous-voie $V_{P\_i}$ sont fournis aux autres sous-voies de la même voie $V_P$.

Dans une étape 103, dans chaque sous-voie $V_{P\_i}$ en parallèle des autres sous-voies de la voie $V_P$, les échantillons filtrés $P(kN+i)$ sont déterminés à l'aide de la formule $P(kN+i) =c(0).x(kN+i) + c(1).x(kN+i -1) + c(2).x(kN+i -2)+... - c(p).x(kN+i -p) + c(p).x(kN+i - p-1)...+c(1).x(kN+i -2.p+1) + c(0).x(kN+i -2.p)$, où $x(n)$ est le résultat de la transposition de fréquence de l'échantillon $z(n)$.

Les résultats intermédiaires déterminés dans chaque sous-voie sont mémorisés et communiqués et/ou accessibles entre sous-voies d'une même voie pour réutilisation dans des étapes de détermination des valeurs des échantillons filtrés de rang supérieur.

Dans une étape 104, les échantillons $I_0(n=4k)$ et $I_2(n=4k+2)$ et, en sortie de la voie Q, les échantillons $Q_1(n=4k+1)$ et $Q_3(n=4k+3)$ sont délivrés simultanément en sortie du DDC 10.

Bien entendu, les modes de réalisation spécifiques décrits plus haut en référence à la figure 3 peuvent également être implémentés par le procédé selon l'invention.

Le convertisseur selon la présente invention permet ainsi de traiter en flux continu les échantillons réels échantillonnées à $F_e$, ici 800 MHz, à la fréquence $F_{FPGA}$ de traitement du FGPA, ici 200 MHz, délivrant un flux continu et en temps réel d'échantillons I à $F_e/2$, ici 400 MHz, et délivrant un flux continu et en temps réel d'échantillons Q à $F_e/2$.

En référence à nouveau au graphe de la figure 1, la zone recouverte par des points Z2 est la zone exploitable en traitement continu et en temps réel selon l'invention. La limitation apportée à la fréquence d'échantillonnage utilisable pour un traitement continu et en temps réel correspond à la vitesse d'échantillonnage maximale du convertisseur analogique-numérique en amont du convertisseur de fréquence et n'est plus limitée par le FPGA.

La parallélisation des traitements sur plusieurs sous-voies I et plusieurs sous-voies Q, l'exploitation des propriétés du filtre et la mémorisation et réutilisation de résultats intermédiaires permettent à la fois de réaliser les traitements à des vitesses réduites, que peuvent supporter les FPGA, et de limiter le nombre des ressources nécessaires.

On notera que la parallélisation des traitements sur plusieurs sous-voies I et plusieurs sous-voies Q peut être mise en oeuvre dans un convertisseur selon l'invention, et ce sans qu'il soit mis en oeuvre de mémorisation et réutilisation de résultats intermédiaires.

Réciproquement, la mémorisation et réutilisation de résultats intermédiaires, exploitant les propriétés des filtres symétriques peuvent être mise en oeuvre dans un convertisseur de fréquence selon l'invention sans qu'il soit mis en oeuvre de parallélisation des traitements sur plusieurs sous-voies I et plusieurs sous-voies Q. En particulier, il a été décrit ci-dessus une application à un convertisseur de fréquence de type descendant, mais l'exploitation des propriétés des filtres symétriques selon l'invention peut dans un autre mode de réalisation être mise en oeuvre dans un convertisseur de fréquence de type ascendant.

Dans le mode de réalisation particulier décrit ci-dessus en référence, il a été considéré une fréquence transposée $f_0$ de 200 MHz, une fréquence d'échantillonnage $F_e$ de 800 MHz et une fréquence de traitement $F_{FPGA}$ de 200 MHz. Bien entendu, l'invention peut être mise en oeuvre pour d'autres valeurs de ces fréquences.

N étant égal au quotient $F_e$ / $F_{FPGA}$, le traitement sera typiquement parallélisé sur N voies pour la voie I, et sur N voies pour la voie Q. La fréquence de traitement $F_{FPGA}$ fixe ainsi le nombre N de voies parallèles à mettre en place, qui pourra ainsi être égal notamment à une puissance de 2 : 2, 4, 8, 16 etc.

Dans des modes de réalisation, la valeur de la fréquence transposée $f_0$ sera en outre fixée égale à $F_e/4$, comme dans le mode de réalisation particulier décrit, de manière à ce que tous les échantillons délivrés par certaines de ces voies parallèles soient systématiquement nuls, de manière à réaliser ainsi, de façon simple, une décimation et à réduire le nombre de sous-voies parallèles.

Par ailleurs le filtre FIR considéré avait des coefficients normalisés par rapport au coefficient central et était symétrique. L'implémentation proposée permet de modifier aisément le nombre de ses coefficients. La valeur de ces derniers dépend de la fréquence d'échantillonnage $F_e$ et est donc à adapter en conséquence. Dans d'autres modes de réalisation, les coefficients ne sont pas normalisés, la réutilisation des résultats intermédiaires pouvant bien entendu être mise en oeuvre également dans ce cas.

Dans le cas d'un mode de réalisation de l'invention avec un filtre FIR non symétrique, les résultats intermédiaires ne peuvent pas être réutilisés. Dans ce cas, le nombre de multiplieurs nécessaires à la mise en oeuvre du filtrage est doublé.

**Revendications**

1.  Convertisseur de fréquences (10) adapté pour recevoir des échantillons de signal et comprenant :

    - au moins un bloc de transposition en fréquence ($11_{Q\_1}$, $11_{Q\_3}$) adapté pour transposer en fréquence lesdits échantillons reçus ;
    - au moins un bloc de filtrage ($12_{Q\_1}$, $12_{Q\_3}$) adapté pour filtrer lesdits échantillons transposés et pour délivrer des échantillons filtrés y(n) vérifiant la formule y(n) =c(0).x(n) + c(1).x(n-1) + c(2).x(n-2)+... + c(p-1).x(n-p+1) + c(p).x(n-p) + c(p-1).x(n-p-1)+...+...+c(1).x(n-2.p+1) + c(0).x(n-2.p), où x() sont les échantillons transposés et c(0),...c(p) sont des coefficients réels du filtre ; et
    - un ensemble de mémoires ;

    ledit convertisseur de fréquences étant adapté pour, lors d'un cycle de détermination de la valeur de l'échantillon filtré y(n), effectuer les opérations de

    - calcul des premiers termes c(0).x(n), c(1).x(n-1), c(2).x(n-2),..., c(p).x(n-p) en multipliant les coefficients et échantillons transposés respectifs, et stockage d'au moins certains desdits premiers termes calculés dans l'ensemble de mémoires ;
    - lecture, dans l'ensemble de mémoires, d'au moins certains des seconds termes c(p-1).x(n-p-1),..., c(1).x(n-2.p+1), c(0).x(n-2.p), calculés et stockés lors de cycles précédents de détermination de la valeur d'échantillons filtrés y(n-m), avec m entier strictement positif ; et
    - détermination de y(n) par sommation des premiers et seconds termes,

    le convertisseur de fréquences (10) étant adapté pour recevoir des échantillons réels échantillonnés de signal et pour délivrer des signaux complexes I/Q, issus du filtrage par le bloc de filtrage après transposition par le bloc de transposition desdits échantillons réels échantillonnés, ledit convertisseur comportant des chaînes parallèles de traitement ($V_I$, $V_Q$) des signaux I et des signaux Q, au moins une desdites chaînes de traitement I, Q comprenant N voies parallèles ($V_{Q\_1}$, $V_{Q\_3}$) adaptées chacune pour effectuer une transposition de fréquence, ledit convertisseur de fréquences étant adapté pour répartir sélectivement les échantillons réels entre lesdites voies, chaque (N.n+i-1)$^{ème}$ échantillon réel étant fourni à la i$^{ème}$ voie, i = 1 à N, n étant un entier positif, au moins la k$^{ème}$ et j$^{ème}$ voies parallèles de ladite chaîne de traitement ($V_Q$), k$\neq$j et k, j entiers entre 1 et N, comprenant un sous-bloc de filtrage adapté pour déterminer le signal filtré y(N.n+i-1) =c(0).x(N.n+i-1) + c(1).x(N.n+i-1-1) + c(2).x(N.n+i-1-2)+... + c(p-1).x(N.n+i-p)+ c(p).x(N.n+i-1-p)+ c(p-1).x(N.n+i-1-p-1)...+c(1).x(N.n+i-1-2.p+1) + c(0).x(N.n+i-1-2.p), où x() sont les signaux issus de la transposition dans ladite chaîne de traitement, avec i = j sur la $j^{\text{ème}}$ voie, et i = k sur la $k^{\text{ème}}$ voie,

le sous-bloc de filtrage ($12_{Q\_1}$, $12_{Q\_3}$) de la $k^{\text{ème}}$ voie, respectivement de la $j^{\text{ème}}$ voie, étant adapté pour calculer les premiers termes c(0).x(N.n+i-1),...,c(p).x(N.n+i-1-p) en multipliant les coefficients et échantillons transposés respectifs, pour stocker d'au moins certains desdits premiers termes calculés dans l'ensemble de mémoires et pour lire, dans l'ensemble de mémoires, au moins certains des seconds termes c(p-1).x(N.n+i-1-p-1),..., c(0).x(N.n+i-1-2.p), calculés et stockés lors de cycles précédents de détermination de la valeur d'échantillons filtrés y(n-m), avec m entier strictement positif, certains desdits seconds termes ayant été calculés par le sous-bloc de filtrage ($12_{Q\_1}$, $12_{Q\_3}$) de la $j^{\text{ème}}$ voie, respectivement de la $k^{\text{ème}}$ voie.

2. Convertisseur de fréquences (10) selon la revendication 1, adapté pour fonctionner de manière cadencée par un signal d'horloge de fréquence, dite fréquence de fonctionnement ($f_{FPGA}$), et adapté pour recevoir les échantillons réels échantillonnées selon une fréquence d'échantillonnage ($F_e$), N étant égal au quotient de la fréquence d'échantillonnage par la fréquence de fonctionnement.

3. Convertisseur de fréquences (10) selon la revendication 2, dans lequel la transposition de fréquence comprend une multiplication des échantillons par un sinus ou cosinus de fréquence (f0) égale à $F_e$/4, N/2 voies délivrant ainsi des échantillons transposés toujours nuls.

4. Procédé de traitement dans un convertisseur de fréquences adapté pour recevoir des échantillons de signal, le procédé comprenant les étapes suivantes :

   - réception des échantillons de signal ;
   - transposition en fréquence desdits échantillons reçus ;
   - filtrage desdits échantillons transposés, les échantillons filtrés y(n) vérifiant la formule y(n) =c(0).x(n) + c(1).x(n-1) + c(2).x(n-2)+... + c(p-1).x(n-p+1) + c(p).x(n-p) + c(p-1).x(n-p-1)+...+...+c(1).x(n-2.p+1) + c(0).x(n-2.p), où x() sont les échantillons transposés et c(0),...c(p) sont des coefficients réels du filtre ;

   ledit procédé de traitement comprenant les étapes suivantes, lors d'un cycle de détermination de la valeur de l'échantillon filtré y(n) :

   - calcul des premiers termes c(0).x(n), c(1).x(n-1), c(2).x(n-2),..., c(p).x(n-p) en multipliant les coefficients et échantillons transposés respectifs, et stockage d'au moins certains desdits premiers termes calculés dans un ensemble de mémoires ;
   - lecture, dans l'ensemble de mémoires, d'au moins certains des seconds termes c(p-1).x(n-p-1),..., c(1).x(n-2.p+1), c(0).x(n-2.p), calculés et stockés lors de cycles précédents de détermination de la valeur d'échantillons filtrés y(n-m), avec m entier strictement positif ; et
   - détermination de y(n) par sommation des premiers et seconds termes,

   le convertisseur de fréquences étant adapté pour recevoir des échantillons réels échantillonnés de signal et délivrer des signaux complexes I/Q issus du filtrage après transposition desdits échantillons réels échantillonnés, ledit procédé comprenant les étapes de :

   - traitement en parallèle des échantillons réels sur une chaîne de traitement I de signaux I et une chaîne de traitement Q de signaux Q ($V_I$, $V_Q$) ;
   - sur au moins une desdites chaînes de traitement parallèle comprenant N voies parallèles ($V_{Q\_1}$, $V_{Q\_3}$), répartition sélective des échantillons réels entre lesdites voies, chaque N.n+i-1)$^{\text{ème}}$ échantillon réel étant fourni à la $i^{\text{ème}}$ voie, i = 1 à N, n étant un entier positif,

   le procédé de traitement comprenant, sur au moins la $k^{\text{ème}}$ et $j^{\text{ème}}$ voies parallèles de ladite chaîne de traitement ($V_Q$), k#j et k, j entiers entre 1 et N, la détermination du signal filtré y(N.n+i-1) =c(0).x(N.n+i-1) + c(1).x(N.n+i-1-1) + c(2).x(N.n+i-1-2)+... + c(p-1).x(N.n+i-p)+ c(p).x(N.n+i-1-p)+ c(p-1).x(N.n+i-1-p-1)...+c(1).x(N.n+i-1-2.p+1) + c(0).x(N.n+i-1-2.p), où x() sont les signaux issus de la transposition dans ladite chaîne de traitement, avec i = j sur la $j^{\text{ème}}$ voie, et i = k sur la $k^{\text{ème}}$ voie,

   et comprenant sur la $k^{\text{ème}}$ voie, respectivement de la $j^{\text{ème}}$ voie, le calcul des premiers termes c(0).x(N.n+i-1),...,c(p).x(N.n+i-1-p) en multipliant les coefficients et échantillons transposés respectifs, le stockage d'au moins certains desdits premiers termes calculés dans l'ensemble de mémoires et la lecture dans l'ensemble de mémoires, d'au moins certains des seconds termes c(p-1).x(N.n+i-1-p-1),..., c(0).x(N.n+i-1-2.p), calculés et stockés lors de cycles précédents de détermination de la valeur d'échantillons filtrés y(n-m), avec m entier strictement positif, sur la $j^{ème}$ voie, respectivement la $k^{eme}$ voie.

5. Procédé de traitement selon la revendication 4, selon lequel le traitement est cadencé par un signal d'horloge de fréquence, dite fréquence de fonctionnement ($f_{FPGA}$), et selon lequel les échantillons réels échantillonnées sont reçus selon une fréquence d'échantillonnage ($F_e$), et N est égal au quotient de la fréquence d'échantillonnage par la fréquence de fonctionnement.

6. Procédé de traitement selon la revendication 5, selon lequel la transposition de fréquence comprend une multiplication des échantillons par un sinus ou cosinus de fréquence (f0) égale à $F_e/4$, N/2 voies délivrant ainsi des échantillons transposés toujours nuls.

**Patentansprüche**

1. Frequenzwandler (10), eingerichtet zum Empfangen von Signal-Abtastwerten und aufweisend:

   - mindestens einen Block zum Transponieren in der Frequenz ($11_{Q\_1}$, $11_{Q\_3}$), eingerichtet zum Transponieren in der Frequenz der empfangenen Abtastwerte;
   - mindestens einen Block zum Filtern ($12_{Q\_1}$, $12_{Q\_3}$), eingerichtet zum Filtern der transponierten Abtastwerte und zum Liefern der gefilterten Abtastwerte y(n), die die Formel y(n)=c(0).x(n) + c(1).x(n-1) + c(2).x(n-2) + ... + c(p-1).x(n-p+1) + c(p).x(n-p) + c(p-1).x(n-p-1) + ...+...+ c(1).x(n-2.p+1) + c(0).x(n-2.p) erfüllen, wobei x() die transponierten Abtastwerte und c(0), ... c(p) die reellen Koeffizienten des Filters sind; und
   - eine Menge von Speichern;

   wobei der Frequenzwandler eingerichtet ist zum, bei einem Zyklus zum Ermitteln des Werts des gefilterten Abtastwerts y(), Ausführen der Operationen des

   - Berechnens der ersten Terme c(0).x(n), c(1).x(n-1), c(2).x(n-2),..., c(p).x(n-p) durch Multiplizieren der Koeffizienten und jeweiligen transponierten Abtastwerte und des Speicherns von mindestens bestimmten der berechneten ersten Terme in der Menge von Speichern;
   - Lesens, in der Menge von Speichern, mindestens bestimmter der zweiten Terme c(p-1).x(n-p-1), ..., c(1).x(n-2.p+1), c(0).x(n-2.p), berechnet und gespeichert bei vorhergehenden Zyklen zum Ermitteln des Werts von gefilterten Abtastwerten y(n-m), wobei m eine ganze Zahl ist, die streng positiv ist; und
   - Ermittelns von y(n) durch Summierung der ersten und der zweiten Terme,

   wobei der Frequenzwandler (10) zum Empfang von reellen, Signal-abgetasteten Abtastwerten und zum Liefern komplexer Signale I/Q, ausgegeben durch die Filterung durch den Block zum Filtern nach Transposition durch den Block zum Transponieren der reellen abgetasteten Abtastwerte, eingerichtet ist,
   wobei der Wandler parallele Ketten zur Verarbeitung ($V_I$, $V_Q$) der Signale I und der Signale Q aufweist, wobei mindestens eine der Ketten zum Verarbeiten von I, Q N parallele Pfade ($V_{Q\_1}$, $V_{Q\_3}$) aufweist, die jeweils eingerichtet sind, eine Frequenz-Transposition durchzuführen,
   wobei der Frequenzwandler eingerichtet ist, die reellen Abtastwerte zwischen den Pfaden aufzuteilen, wobei jeder (N.n+i-1)-te Abtastwert dem i-ten Pfad zugeführt wird, i = 1 bis N, wobei n eine positive ganze Zahl ist,
   wobei mindestens der k-te und der j-te parallele Pfad der Verarbeitungskette ($V_Q$), $k \neq j$ und k, j ganze Zahlen zwischen 1 und N, einen Unterblock zum Filtern aufweist, der eingerichtet ist, das gefilterte Signal y(N.n+i-1)=c(0).x(N.n+i-1) + c(1).x(N.n+i-1-1) + c(2).x(N.n+i-1-2) + ... + c(p-1).x(N.n+i-1-p) + c(p).x(N.n+i-1-p) + c(p-1).x(N.n+i-1-p-1) + ...+...+ c(1).x(N.n+i-1-2.p+1) + c(0).x(N.n+i-1-2.p) zu ermitteln, wobei x() die von der Transposition in der Verarbeitungskette ausgegebenen Werte sind, mit i = j auf dem j-ten Pfad und i = k auf dem k-ten Pfad,
   wobei der Unterblock zum Filtern ($12_{Q\_1}$, $12_{Q\_3}$) des k-ten Pfads bzw. des j-ten Pfads eingerichtet ist zum Berechnen der ersten Terme c(0).x(N.n+i-1), ..., c(p).x(N.n+i-1-p) durch Multiplizieren der Koeffizienten und jeweiligen transponierten Stichproben, zum Speichern von zumindest bestimmten der ersten berechneten Terme in der Menge von Speichern und zum Lesen, in der Menge von Speichern, von zumindest bestimmten der zweiten Terme c(p-1).x(N.n+i-1-p-1), ..., c(0).x(N.n+i-1-2.p), berechnet und gespeichert bei vorhergehenden Zyklen zum Ermitteln des Werts von gefilterten Abtastwerten y(n-m), wobei m eine ganze Zahl ist, die streng positiv ist, wobei bestimmte der zweiten Terme durch den Unterblock zum Filtern ($12_{Q\_1}$, $12_{Q\_3}$) des j-ten Pfads bzw. des k-ten Pfads berechnet wurden.

2. Frequenzwandler (10) gemäß Anspruch 1, eingerichtet zum Arbeiten auf getaktete Weise mittels eines Frequenztaktsignals, bezeichnet als Betriebsfrequenz ($f_{FPGA}$), und eingerichtet zum Empfangen der reellen Abtastwerte, abgetastet gemäß einer Abtast-Frequenz ($F_e$), wobei N gleich dem Quotienten der Abtastfrequenz durch die Betriebsfrequenz ist.

3. Frequenzwandler (10) gemäß Anspruch 2, in dem die Frequenztransposition eine Multiplikation der Abtastwerte mit einem Sinus oder Kosinus mit einer Frequenz (f0) gleich $F_e$/4 aufweist, wobei N/2 Pfade somit transponierte Abtastwerte liefern, die immer Null sind.

4. Verfahren zum Verarbeiten in einem Frequenzwandler, eingerichtet zum Empfangen von Signal-Abtastwerten, wobei das Verfahren die folgenden Schritte aufweist:

   - Empfangen von Signal-Abtastwerten;
   - Transponieren der empfangenen Abtastwerte in der Frequenz;
   - Filtern der transponierten Abtastwerte, wobei die gefilterten Abtastwerte y(n) die Formel y(n)=c(0).x(n) + c(1).x(n-1) + c(2).x(n-2) + ... + c(p-1).x(n-p+1) + c(p).x(n-p) + c(p-1).x(n-p-1) + ...+...+ c(1).x(n-2.p+1) + c(0).x(n-2.p) erfüllen, wobei x() die transponierten Abtastwerte und c(0), ... c(p) die reellen Koeffizienten des Filters sind; und

   wobei das Verfahren zum Verarbeiten die folgenden Schritte aufweist, bei einem Zyklus zum Ermitteln des Werts des gefilterten Abtastwerts y():

   - Berechnen der ersten Terme c(0).x(n), c(1).x(n-1), c(2).x(n-2),..., c(p).x(n-p) durch Multiplizieren der Koeffizienten und jeweiligen transponierten Abtastwerte und Speichern von mindestens bestimmten der berechneten ersten Terme in einer Menge von Speichern;
   - Lesen, in der Menge von Speichern, mindestens bestimmter der zweiten Terme c(p-1).x(n-p-1), ..., c(1).x(n-2.p+1), c(0).x(n-2.p), berechnet und gespeichert bei vorhergehenden Zyklen zum Ermitteln des Werts von gefilterten Abtastwerten y(n-m), wobei m eine ganze Zahl ist, die streng positiv ist; und
   - Ermitteln von y(n) durch Summierung der ersten und der zweiten Terme,

   wobei der Frequenzwandler zum Empfangen von reellen, Signal-abgetasteten Abtastwerten und zum Liefern komplexer Signale I/Q eingerichtet ist, ausgegeben durch die Filterung nach Transposition der reellen abgetasteten Abtastwerte, wobei das Verfahren die Schritte aufweist:

   - paralleles Verarbeiten der reellen Abtastwerte auf einer Kette zur Verarbeitung I des Signals I und einer Kette der Verarbeitung Q des Signals Q. (VI, $V_Q$);
   - auf mindestens einer der Ketten zum parallelen Verarbeiten, die N parallele Pfade ($V_{Q\_1}$, $V_{Q\_3}$) aufweist,

   selektives Aufteilen der reellen Abtastwerte zwischen den Pfaden, wobei jeder (N.n+i-1)-te Abtastwert dem i-ten Pfad zugeführt wird, i = 1 bis N, wobei n eine positive ganze Zahl ist, wobei das Verfahren zum Verarbeiten auf mindestens dem k-ten und dem j-ten parallelen Pfad der Verarbeitungskette ($V_Q$), k≠j und k, j ganze Zahlen zwischen 1 und N, das Ermitteln des gefilterten Signals y(N.n+i-1)=c(0).x(N.n+i-1) + c(1).x(N.n+i-1-1) + c(2).x(N.n+i-1-2) + ... + c(p-1).x(N.n+i-1-p) + c(p).x(N.n+i-1-p) + c(p-1).x(N.n+i-1-p-1) + ...+...+ c(1).x(N.n+i-1-2.p+1) + c(0).x(N.n+i-1-2.p) aufweist, wobei x() die von der Transposition in der Verarbeitungskette ausgegebenen Werte sind, mit i = j auf dem j-ten Pfad und i = k auf dem k-ten Pfad, und auf dem k-ten Pfad bzw. dem j-ten Pfad das Berechnen der ersten Terme c(0).x(N.n+i-1), ..., c(p).x(N.n+i-1-p) durch Multiplizieren der Koeffizienten und jeweiligen transponierten Stichproben, das Speichern von zumindest bestimmten der ersten berechneten Terme in der Menge von Speichern und das Lesen in der Menge von Speichern von zumindest bestimmten der zweiten Terme c(p-1).x(N.n+i-1-p-1), ..., c(0).x(N.n+i-1-2.p), berechnet und gespeichert bei vorhergehenden Zyklen zum Ermitteln des Werts von gefilterten Abtastwerten y(n-m), wobei m eine ganze Zahl ist, die streng positiv ist, auf dem j-ten Pfad bzw. dem k-ten Pfad, aufweist.

5. Verfahren zum Verarbeiten gemäß Anspruch 4, gemäß dem das Verarbeiten mittels eines Frequenztaktsignals, bezeichnet als Betriebsfrequenz ($f_{FPGA}$), getaktet ist, und gemäß dem die reellen, abgetasteten Abtastwerte, gemäß einer Abtast-Frequenz ($F_e$) empfangen werden, wobei N gleich dem Quotienten der Abtastfrequenz durch die Betriebsfrequenz ist.

6. Verfahren zum Verarbeiten gemäß Anspruch 5, gemäß dem die Frequenztransposition eine Multiplikation der Abtastwerte mit einem Sinus oder Kosinus mit einer Frequenz (f0) gleich $F_e$/4 aufweist, wobei N/2 Pfade somit transponierte Abtastwerte liefern, die immer Null sind.

**Claims**

1. A frequency converter (10) adapted for receiving signal samples and comprising:

   - at least one frequency transposition block ($11_{Q\_1}$, $11_{Q\_3}$) adapted for transposing in frequency said received samples;
   - at least one filtering block ($12_{Q\_1}$, $12_{Q\_3}$) adapted for filtering said transposed samples and for delivering filtered samples y(n) verifying the formula y(n) =c(0).x(n) + c(1).x(n-1) + c(2).x(n-2)+... + c(p-1).x(n-p+1) + c(p).x(n-p) + c(p-1).x(n-p-1)+...+...+c(1).x(n-2.p+1) + c(0).x(n-2.p), wherein x() are transposed samples and c(0),...c(p) are real coefficients of the filter; and
   - a set of memories;

   said frequency converter being adapted for, during a cycle for determining the value of the filtered sample y(n), carrying out operations for

   - calculating the first terms c(0).x(n), c(1).x(n-1), c(2).x(n-2),..., c(p).x(n-p) by multiplying the respective coefficients and transposed samples, and storing at least certain of said first calculated terms in the set of memories;
   - reading, in the set of memories, at least certain of the second terms c(p-1).x(n-p-1),..., c(1).x(n-2.p+1), c(0).x(n-2.p), calculated and stored during the previous cycles for determining the value of filtered samples y(n-m), with m being a strictly positive integer; and
   - determining y(n) by summation of the first and second terms,

   the frequency converter (10) being adapted for receiving sampled real signal samples and for delivering complex signals I/Q, from the filtering by the filtering block after transposition with the transposition block of said sampled real samples,
   said converter including parallel chains for processing ($V_I$, $V_Q$) of the signals I and of the signals Q, at least one of said processing chains I, Q comprising N parallel routes ($V_{Q\_1}$, $V_{Q\_3}$) each adapted for carrying out frequency transposition, said frequency converter being adapted for selectively distributing the real samples between said routes, each (N.n+i-1)$^{1h}$ real sample being provided to the i$^{th}$ route, i = 1 to N, n being a positive integer, at least the k$^{th}$ and j$^{th}$ parallel routes of said processing chain ($V_Q$), k≠j and k, j integers between 1 and N, comprising a filtering sub-block adapted for determining the filtered signal y(N.n+i-1) =c(0).x(N.n+i-1) + c(1).x(N.n+i-1-1) + c(2).x(N.n+i-1-2)+... + c(p-1).x(N.n+i-p)+ c(p).x(N.n+i-1-p)+ c(p-1).x(N.n+i-1-p-1)...+c(1).x(N.n+i-1-2.p+1) + c(0).x(N.n+i-1-2.p), wherein x() are signals from the transposition in said processing chain, with i = j on the j$^{th}$ route, and i = k on the k$^{th}$ route,
   the filtering sub-block ($12_{Q\_1}$, $12_{Q\_3}$) of the k$^{th}$ route, respectively of the j$^{th}$ route, being adapted for calculating the first terms c(0).x(N.n+i-1),...,c(p).x(N.n+i-1-p) by multiplying the respective coefficients and transposed samples, in order to store at least certain of said first terms calculated in the set of memories and for reading, in the set of memories, at least certain of the second terms c(p-1).x(N.n+i-1-p-1),..., c(0).x(N.n+i-1-2.p), calculated and stored during previous cycles for determining the value of filtered samples y(n-m), with m being a strictly positive integer, certain of said second terms having been calculated by the filtering sub-block ($12_{Q\_1}$, $12_{Q\_3}$) of the j$^{th}$ route, respectively of the k$^{th}$ route.

2. The frequency converter (10) according to claim 1, adapted for operating in a way clocked by a clock frequency signal, a so called operating frequency ($f_{FPGA}$), and adapted for receiving the real samples sampled according to a sampling frequency ($F_e$), N being equal to the quotient of the sampling frequency by the operating frequency.

3. The frequency converter (10) according to claim 2, wherein the frequency transposition comprises a multiplication of the samples with a sine or cosine of frequency (f0) equal to $F_e$/4, N/2 routes thereby delivering always zero transposed samples.

4. The processing method in a frequency converter adapted for receiving signal samples, the method comprising the following steps:

   - receiving the signal samples;

EP 3 175 550 B1

- transposing in frequency said received samples;
- filtering said transposed samples, the filtered samples y(n) verifying the formula y(n) =c(0).x(n) + c(1).x(n-1) + c(2).x(n-2)+... + c(p-1).x(n-p+1) + c(p).x(n-p) + c(p-1).x(n-p-1)+...+...+c(1).x(n-2.p+1) + c(0).x(n-2.p), wherein x() are the transposed samples and c(0),...c(p) are the real coefficients of the filter;

said processing method comprising the following steps, during a cycle for determining the value of the filtered sample y(n):

- calculating the first terms c(0).x(n), c(1).x(n-1), c(2).x(n-2),..., c(p).x(n-p) by multiplying the respective coefficients and transposed samples, and storing at least certain of said first terms calculated in a set of memories;
- reading, in the set of memories, at least certain of the second terms c(p-1).x(n-p-1),..., c(1).x(n-2.p+1), c(0).x(n-2.p), calculated and stored during previous cycles for determining the value of filtered samples y(n-m), with m being a strictly positive integer; and
- determining y(n) by summation of the first and second terms,

the frequency converter being adapted for receiving sampled real signal samples and delivering complex I/Q signals from the filtering after transposition of said sampled real samples, said method comprising the steps:

- processing in parallel the real samples on a processing chain I for signals I and a Q processing chain for signals Q ($V_I$, $V_Q$);
- on at least one of said parallel processing chains comprising N parallel routes ($V_{Q\_1}$, $V_{Q\_3}$), selective distribution of the real samples among said routes, each real $(N.n+i-1)^{1h}$ sample being provided to the $i^{th}$ route, i = 1 to N, n being a positive integer,

the processing method comprising, on at least the $k^{th}$ and $j^{lh}$ parallel routes of said processing chain ($V_Q$), k≠j and k, j integers between 1 and N, the determination of the filtered signal y(N.n+i-1) =c(0).x(N.n+i-1) + c(1).x(N.n+i-1-1) + c(2).x(N.n+i-1-2)+... + c(p-1).x(N.n+i-p)+ c(p).x(N.n+i-1-p)+ c(p-1).x(N.n+i-1-p-1)...+c(1).x(N.n+i-1-2.p+1) + c(0).x(N.n+i-1-2.p), wherein x() are signals from the transposition in said processing chain, with i = j on the $j^{th}$ route, and i = k on the $k^{th}$ route,

and comprising on the $k^{th}$ route, respectively the $j^{th}$ route, the calculation of the first terms c(0).x(N.n+i-1),...,c(p).x(N.n+i-1-p) by multiplying the respective coefficients and transposed samples, the storage of at least certain of said first calculated terms in the set of memories and the reading in the set of memories, of at least certain of the second terms c(p-1).x(N.n+i-1-p-1),..., c(0).x(N.n+i-1-2.p), calculated and stored during previous cycles for determining the value of filtered samples y(n-m), with m being a strictly positive integer, on the $j^{th}$ route, respectively the $k^{th}$ route.

5. The processing method according to claim 4, according to which the processing operation is clocked by a clock frequency signal, a so called operating frequency ($f_{FPGA}$), and according to which the sampled real samples are received according to a sampling frequency ($F_e$), and N is equal to the quotient of the sampling frequency by the operating frequency.

6. The processing method according to claim 5, according to which the frequency transposition comprises a multiplication of the samples by a sine or cosine of frequency (f0) equal to $F_e/4$, N/2 routes thereby delivering always zero transposed samples.

$$f_{FPGA}$$

Z1

$f_{FPGA\_MAX}$

$F_{e1}$   $F_{e2}$   $F_e$

Z2

<u>FIG.1</u>

$11_I$   $12_I$   $13_I$   $10$

$V_I$

$\cos(2\Pi f_0 t_n)$

$\downarrow 2$

$I (F_{e/2})$

$z(n)$

$(F_e)$

$\sin(2\Pi f_0 t_n)$

$V_Q$

$\downarrow 2$

$Q (F_{e/2})$

$(F_{FPGA})$

$11_Q$   $12_Q$   $13_Q$

<u>FIG.2</u>

14

$11_{I\_0}$  $12_{I\_0}$

$V_{I\_0}$ | x1 | $z^{-13}$ | → $I_0$ (n=4k)

$V_I$

$V_{I\_1}$  x

$11_{I\_2}$  $12_{I\_2}$

$V_{I\_2}$ | x-1 | $z^{-13}$ | → $I_2$ (n=4k+2)

$I_{(400\ MHz)}$

$V_{I\_3}$  x

15

z(n)

($F_e$ = 800 MHz)

$V_{Q\_0}$  x

$11_{Q\_1}$  $12_{Q\_1}$

$V_{Q\_1}$ | x-1 | | → $Q_1$ (n=4k+1)

$V_{Q\_2}$  x

$12_{Q\_3}$

$V_Q$

$V_{Q\_3}$ | x1 | | → $Q_3$ (n=4k+3)

$Q_{(400\ MHz)}$

($F_{FPGA}$ =200 MHz)

$11_{Q\_3}$

## FIG.3

-101-

-102-

-103-

-104-

## FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5841811 A

- US 2004056785 A

**Littérature non-brevet citée dans la description**

- **J.M.P. LANGLOIS et al.** A High Performance, Wide Bandwidth, Low Cost FPGA-Based Quadrature Demodulator. *Proceedings of the 1999 IEEE Canadian Conférence on Electrical and Computer Engineering,* 09 Mai 1999, 497-502